# EUROPÄISCHE PATENTSCHRIFT

(11) **EP 3 969 691 B1**
(45) Veröffentlichungstag und Bekanntmachung des Hinweises auf die Patenterteilung: **12.11.2025**
(21) Anmeldenummer: 20740190.2
(22) Anmeldetag: 17.05.2020
(51) Int. Cl.: E04H 12/00, F03D 13/20, F03D 9/00, H02S 10/12

(54) **SÄULE MIT MINDESTENS EINEM PHOTOVOLTAISCHEN ELEMENT UND VERWENDUNG EINES PHOTOVOLTAISCHEN ELEMENTS AN EINER SÄULE**
COLUMN HAVING AT LEAST ONE PHOTOVOLTAIC ELEMENT, AND USE OF A PHOTOVOLTAIC ELEMENT ON A COLUMN
COLONNE COMPRENANT AU MOINS UN ÉLÉMENT PHOTOVOLTAÏQUE ET UTILISATION D'UN ÉLÉMENT PHOTOVOLTAÏQUE SUR UNE COLONNE

(30) Priorität: 17.05.2019 DE 102019113016
(43) Veröffentlichungstag der Anmeldung: 23.03.2022
(73) Patentinhaber: Heliatek GmbH, 01139 Dresden (DE)
(72) Erfinder: HERMENAU, Martin, 01139 Dresden (DE); KRENZ, Hannes, 01139 Dresden (DE); CHRISTARAS, Spyridon, 01139 Dresden (DE)
(86) Internationale Anmeldenummer: PCT/DE2020/100429
(87) Internationale Veröffentlichungsnummer: WO 2020/233748

(56) Entgegenhaltungen:
- WO-A1-2018/232324
- CN-A- 104 779 896
- CN-A- 104 948 380
- CN-A- 108 923 725
- KR-A- 20160 046 092
- US-A1- 2010 207 453
- US-A1- 2017 331 426
- US-B1- 7 932 621

## Beschreibung

Die vorliegende Erfindung betrifft Säulen mit mindestens einem flexiblen photovoltaischen Element, insbesondere einer Solarzelle, zur Umwandlung von Strahlungsenergie des Lichts in elektrische Energie, Windkraftanlagen zur Umwandlung von Strömungsenergie des Winds in elektrische Energie mit mindestens einem flexiblen photovoltaischen Element, insbesondere einer Solarzelle, zur Umwandlung von Strahlungsenergie des Lichts in elektrische Energie, sowie die Verwendung mindestens eines flexiblen photovoltaischen Elements, insbesondere einer Solarzelle, an einer Säule oder an einer Windkraftanlage.

Die Gewinnung von elektrischer Energie aus erneuerbaren Quellen spielt eine immer größere Rolle, dabei kommen der Gewinnung von elektrischer Energie durch Sonnenenergie und Windkraft eine besondere Bedeutung zu.

Die Verwendung von Solarzellen zur Gewinnung von elektrischer Energie aus Licht ist aus dem Stand der Technik bekannt. Solarzellen sind in verschiedenen Ausführungsformen bekannt. Solarzellen sind aus einer photoaktiven Schicht ausgebildet, die meistens in einem Rahmen integriert ist. Die Befestigung solcher Solarpanele ist dabei an Gebäuden, insbesondere auf Dächern, oder auf freien Flächen möglich.

Die Verwendung von Windkraftanlagen zur Erzeugung von elektrischer Energie aus der Windkraft ist ebenso aus dem Stand der Technik bekannt. Windkraftanlagen sind aus einer in vertikaler Richtung aufgestellten Säule mit einer daran an einem Ende angeordneten Turbine mit Rotorblättern ausgebildet.

Es ist ebenfalls bekannt, Windkraftanlagen und Solarzellen gemeinsam zur Erzeugung von elektrischer Energie zu verwenden.

Aus dem Stand der Technik sind zahlreiche Rotorblätter für Windkraftanlagen mit Solarzellen bekannt.

Die US-Patentanmeldung US 5,254,876 A offenbart die Kombination von Windkraftanlagen und Solarzellen, die an Rotorblättern der Windkraftanlage angeordnet sind.

Die US-Patentanmeldung US 7,045,702 A offenbart eine Windmühle mit Solarpanelen, wobei die Solarpanele auf den Flügeln der Windmühle angeordnet sind.

Die US-Patentschrift US 8,288,884 B1 offenbart eine Windkraftanlage mit integrierten Solarpanelen, wobei die Solarpanele an einem Turm der Windkraftanlage befestigt sind. Dabei sind die Solarpanele mittels einer zusätzlichen Konstruktion an dem Turm angebracht, wobei die Solarpanele verschiebbar und/oder neigbar sind.

CN 108 923 725 A ist ein weiteres relevantes Beispiel für den Stand der Technik.

Ziel der vorliegenden Erfindung ist es eine Säule mit mindestens einem photovoltaischen Element und eine Windkraftanlage mit einer solchen Säule bereitzustellen, wobei die im Folgenden genannten Nachteile nicht auftreten, und wobei insbesondere die Oberfläche einer Säule, insbesondere der Säule einer Windkraftanlage, zur Energiegewinnung effektiver genutzt werden kann, und wobei insbesondere eine bessere Effizienz bei Verschattung einzelner teil- und/oder vollverschatteter Zellen erreicht wird.

Nachteilig aus dem Stand der Technik ist jedoch, dass die Solarzellen nicht formschlüssig und damit direkt auf einer Oberfläche einer Säule angeordnet sind. Solarpanele, die insbesondere in einem festen Rahmen auf der Oberfläche der Säule angeordnet sind, stehen mit einem großen Teil deren Oberfläche von der Säule ab. Dadurch sind die Solarpanele besonders anfällig für Schäden durch Wettereinflüsse, insbesondere starkem Wind, und beeinflussen die Strömung des Winds an den Rotorblättern, wodurch die Effektivität der Windkraftanlage erheblich reduziert wird. Ebenso die auf Rotorblättern aufgebrachten Solarzellen oder auf den Flügeln aufgebrachten Solarpanelen werden durch die Rotation noch stärkeren Kräften ausgesetzt und beeinflussen die Strömung des Windes an den Rotorblättern.

Die aus dem Stand der Technik bekannten Kombinationen von Windkraftanlagen und Photovoltaikanlagen sind also insofern nachteilig, dass die Effektivität der Windkraftanlage beeinträchtigt wird. Aus dem Stand der Technik sind jedoch keine Säulen bekannt, auf denen photovoltaische Elemente formschlüssig auf der Oberfläche einer Säule angeordnet sind, insbesondere aufgeklebt sind.

Der Erfindung liegt daher die Aufgabe zugrunde, eine Säule mit mindestens einem photovoltaischen Element zur Umwandlung von Strahlungsenergie des Lichts, insbesondere des Sonnenlichts, in elektrische Energie und/oder eine Windkraftanlage mit einer solchen Säule bereitzustellen, wobei die genannten Nachteile nicht auftreten, und wobei insbesondere eine Säule effektiv zur Energiegewinnung genutzt werden kann, und insbesondere die Effektivität einer Windkraftanlage nicht beeinträchtigt wird. Die Aufgabe wird durch die Gegenstände der unabhängigen Ansprüche gelöst. Vorteilhafte Ausgestaltungen ergeben sich aus den Unteransprüchen.

Die Aufgabe wird insbesondere gelöst, indem eine Säule mit mindestens einem photovoltaischen Element zur Umwandlung von Strahlungsenergie des Lichts, insbesondere des Sonnenlichts, in elektrische Energie bereitgestellt wird, wobei das mindestens eine photovoltaische Element an der Säule angeordnet ist, und wobei das mindestens eine photovoltaische Element ein flexibles photovoltaisches Element ist.

Gemäß der Erfindung ist das photovoltaische Element formschlüssig mit der Säule verbunden, insbesondere formschlüssig an der Oberfläche der Säule befestigt. In einer bevorzugten Ausführungsform ist das mindestens eine photovoltaische Element derart auf der Säule formschlüssig fixiert, dass das mindestens eine photovoltaische Element vor Wettereinflüssen zumindest weitgehend geschützt ist, insbesondere Hagel, Schnee oder Wind. Dies ist insbesondere bei der Installation des mindestens einen photovoltaischen Elements an einer Windkraftanlage vorteilhaft, da diese bestimmungsgemäß in einem Gebiet mit häufigem und stärkerem Wind installiert ist. Die erfindungsgemäße Säule mit dem mindestens einen photovoltaischen Element weist Vorteile im Vergleich zum Stand der Technik auf. Vorteilhafterweise wird eine effektive Kombination der Erzeugung von elektrischer Energie aus Windenergie und der Erzeugung von elektrischer Energie aus Sonnenenergie ermöglicht. Vorteilhafterweise wird die Oberfläche der Säule effektiv genutzt, insbesondere da keine Rahmen herkömmlicher photovoltaischer Elemente die Anbringung weiterer photovoltaischer Elemente behindern. Vorteilhafterweise kann auf weitere Bauteile, wie einen Rahmen oder ein Gerüst zur Stabilisierung und/oder Befestigung des photovoltaischen Elements verzichtet werden, insbesondere durch eine formschlüssige Befestigung des photovoltaischen Elements direkt auf der Oberfläche der Säule. Vorteilhafterweise sind die Solarzellen formschlüssig auf der Säule angebracht und damit weniger anfällig gegenüber einer Beschädigung durch Wind oder andere Wettereinflüsse. Vorteilhafterweise sind durch den Wind erzeugte Geräusche im Vergleich zu üblicherweise abstehenden Solarpanelen reduziert. Vorteilhafterweise werden bereits vorhandene Flächen der Säule zum Anordnen der photovoltaischen Elemente genutzt, wodurch keine zusätzliche Fläche benötigt wird. Vorteilhafterweise sind die photovoltaischen Elemente der Form der Säule angepasst, wodurch eine höhere Stabilität im Hinblick auf starke Winde und einer dadurch verursachten Beschädigung erreicht wird. Vorteilhafterweise sind die flexiblen photovoltaischen Elemente besonders leicht, wodurch eine größere Anzahl an photovoltaischen Elemente an der Säule befestigbar ist, ohne ein bestimmtes Gewicht zu überschreiten.

Unter einer Säule wird insbesondere auch ein Pfeiler, insbesondere ein Brücken- oder Stützpfeiler, ein Turm, insbesondere ein Kamin, ein Schornstein, ein Sende- oder Strommast oder ein Fernsehturm, oder ein Silo oder ein Telefon-, Telegraphen- oder Oberleitungs- oder Laternenmast oder Pylon verstanden. In einer bevorzugten Ausführungsform ist die Säule eine Säule einer Windkraftanlage.

Unter einem photovoltaischen Element wird insbesondere eine optoelektronische Zelle oder eine Solarzelle verstanden. Das photovoltaische Element ist insbesondere ein Modul aus mehreren Zellen, die in Reihe oder parallel verschaltet sein können, wobei bevorzugt eine Zelle ihre längste Ausdehnung über die Länge des Moduls oder über die Breite des Moduls aufweist.

Gemäß der Erfindung ist das flexible photovoltaische Element eine Perovskit-Zelle oder ein organisches Photovoltaik-Element (OPV), insbesondere ein polymeres organisches Photovoltaik-Element oder ein organisches Photovoltaik-Element auf Basis kleiner Moleküle. Insbesondere bevorzugt ist das photovoltaische Element ein flexibles organisches Photovoltaik-Element (OPV) auf Basis kleiner Moleküle.

Unter einem organischen Photovoltaik-Element (OPV) wird insbesondere ein photovoltaisches Element mit mindestens einer organischen photoaktiven Schicht verstanden.

Unter kleinen Molekülen werden insbesondere nicht-polymere organische Moleküle mit monodispersen molaren Massen zwischen 100 und 2000 g/mol verstanden, die unter Normaldruck (Luftdruck der uns umgebenden Atmosphäre) und bei Raumtemperatur in fester Phase vorliegen. Insbesondere sind die kleinen Moleküle photoaktiv, wobei unter photoaktiv verstanden wird, dass die Moleküle unter Lichteintrag ihren Ladungszustand und/oder ihren Polarisierungszustand ändern.

In einer bevorzugten Ausführungsform ist das organische Photovoltaik-Element aus mindestens einer Zelle ausgebildet. In einer bevorzugten Ausführungsform ist die Zelle als eine Single-, Tandem- oder Mehrfachzelle ausgeführt. Tandem- und Mehrfachzellen bestehen aus mindestens zwei Zellen, die übereinander zwischen den Elektroden angeordnet sind, wobei jede Zelle mindestens eine photoaktive Schicht umfasst. Unter photoaktive Schicht wird die Schicht bzw. der Schichtstapel innerhalb einer Zelle verstanden, die in einem organischen photovoltaischen Element zur Generierung der Ladungsträger einen Beitrag bildet. Deshalb kann das organische photovoltaische Elemente noch weitere Schichten, wie beispielsweise Ladungsträger-Transportschichten, die dotiert sein können, aufweisen. Ein möglicher Aufbau von organischen photovoltaischen Elementen ist in WO 2004 083 958 A2,
WO 2011 013 219 A1, WO 2011 138 021 A2 und WO 2011 161 108 A1 offengelegt.

In einer bevorzugten Ausführungsform weist die photoaktive Schicht kleine Moleküle auf.

In einer Ausführungsform sind mehrere Zellen als Streifen mit Kontakten nebeneinander angeordnet und in Reihe verschaltet. Jede Zelle hat dabei seine eigene Grundelektrode und Deckelektrode. Die Reihenschaltung erfolgt beispielsweise durch elektrisches Verbinden der Grundelektrode einer Zelle mit der Deckelektrode der nächsten Zelle. In einer Ausführungsform ist jeder Zelle oder einer Gruppe von Zellen eine integrierte Bypass-Diode oder ein Element zur Vermeidung von Verlusten bei Verschattung zugeordnet.

In einer Ausführungsform umfasst die photoaktive Schicht Absorbermaterialien, die verdampfbar sind und durch Verdampfung auf eine Trägerfolie aufgebracht sind. Dafür werden Materialien die zur Gruppe der "kleinen Moleküle" gehören, verwendet, die unter anderem in WO 2006 092 134 A1, WO 2010 133 208 A1,
WO 2014 206 860 A1, WO 2014 128 278 A1, EP 31 87 496 A1, und EP 31 88 270 B1 beschrieben sind.

In einer bevorzugten Ausführungsform ist das mindestens eine photovoltaische Element mit zusätzlich mindestens einer aufgebrachten Barriereschicht versehen und/oder eingekapselt, um eine Degradierung durch äußere Einflüsse zu minimieren. Weiterhin kann eine Passivierungsschicht zum Schutz der mindestens einen photoaktiven Schicht aufgebracht sein und/oder eine Planarisierungsschicht aufgebracht sein.

Unter einem flexiblen photovoltaischen Element wird insbesondere ein photovoltaisches Element verstanden, dass in einem bestimmten Bereich biegbar und/oder dehnbar ist.

In einer bevorzugten Ausführungsform weist das flexible photovoltaische Element einen Biegeradius von kleiner 50 cm , bevorzugt von kleiner 20 cm, oder bevorzugt von kleiner 10 cm, oder bevorzugt von kleiner 5 cm auf. Vorzugsweise wird die Flexibilität des flexiblen photovoltaischen Elements durch den Biegeradius gekennzeichnet. Dadurch wird sichergestellt, dass sich das flexible photovoltaische Element an die Form der Oberfläche der Säule anpassbar ist.

Gemäß der Erfindung weist das flexible photovoltaische Element einen positiven Temperaturkoeffizienten auf. Dadurch kann das flexible photovoltaische Element formschlüssig und damit direkt auf der Oberfläche der Säule angeordnet sein, da kein Abstand für eine Hinterlüftung des flexiblen photovoltaischen Elements notwendig ist.

Unter einer Längsrichtung wird insbesondere die Richtung der längsten Ausdehnung einer Säule oder eines photovoltaischen Elements verstanden, insbesondere ist die Längsrichtung die längste Ausdehnung einer Säule einer Windkraftanlage, auf der ein photovoltaisches Element angeordnet ist. Bei der Längsrichtung handelt es sich insbesondere um die Richtung, in der eine Säule bestimmungsgemäß aufgestellt ist, also um die vertikale Richtung.

Unter einer Querrichtung wird insbesondere die Richtung senkrecht zur Längsrichtung verstanden, also um die horizontale Richtung.

In einer bevorzugten Ausführungsform ist das mindestens eine photovoltaische Element vertikal und/oder horizontal auf der Säule angeordnet, bezogen auf die längste Ausdehnung des photovoltaischen Elements und/oder die Anordnung der Zellen in dem photovoltaischen Element.

Gemäß einer Weiterbildung der Erfindung ist vorgesehen, dass das mindestens eine flexible photovoltaische Element quer und/oder längs, und/oder auch schräg, relativ zu der längsten Ausdehnung der Säule angeordnet ist. Das mindestens eine photovoltaische Element kann dabei auf unterschiedlich ausgebildeten Säulen angeordnet sein.

In einer bevorzugten Ausführungsform erstreckt sich das mindestens eine photovoltaische Element zumindest weitgehend über die gesamte Länge der Säule.

In einer bevorzugten Ausführungsform beträgt die Länge der Säule 2 m, bevorzugt 3 m, bevorzugt 5 m, bevorzugt 10 m, bevorzugt 20 m, bevorzugt 30 m, bevorzugt 50 m, bevorzugt 80 m, bevorzugt 100 m, bevorzugt 120 m, oder mehr.

Gemäß einer Weiterbildung der Erfindung ist vorgesehen, dass die Säule mindestens zwei Reihen an flexiblen photovoltaischen Elementen aufweist, wobei die mindestens zwei Reihen an flexiblen photovoltaischen Elementen quer und/oder längs, und/oder auch schräg, relativ zu der längsten Ausdehnung der Säule angeordnet sind, und wobei eine Reihe bevorzugt mindestens zwei flexible photovoltaische Elemente aufweist.

In einer bevorzugten Ausführungsform ist das mindestens eine photovoltaische Element vertikal und/oder horizontal zur Längsrichtung der Säule angeordnet.

In einer bevorzugten Ausführungsform ist die Breite des mindestens einen photovoltaischen Elements größer als 20 cm, bevorzugt größer als 30 cm, bevorzugt größer als 50 cm, bevorzugt größer als 60 cm, bevorzugt größer als 80 cm, oder bevorzugt größer als 1 m.

In einer bevorzugten Ausführungsform ist die Länge des mindestens einen photovoltaischen Elements größer als 2 m, bevorzugt größer als 5 m, bevorzugt größer als 6 m, oder bevorzugt größer als 10 m.

In einer besonders bevorzugten Ausführungsform ist die Länge des mindestens einen photovoltaischen Elements der Ausdehnung der Säule angepasst, so dass die Oberfläche der Säule zumindest weitgehend genutzt wird. In einer bevorzugten Ausführungsform ist die Länge mehrerer auf der Säule befestigten photovoltaischen Elemente unterschiedlich.

In einer bevorzugten Ausführungsform ist eine Vielzahl an photovoltaischen Elementen auf der Säule angeordnet, insbesondere werden die photovoltaischen Elemente bündig relativ zueinander angeordnet. In einer bevorzugten Ausführungsform sind die photovoltaischen Elemente auf der Säule parallel zueinander angeordnet. In einer bevorzugten Ausführungsform ist die Säule vollständig oder weitgehend vollständig mit photovoltaischen Elementen beschichtet.

Gemäß einer Weiterbildung der Erfindung ist vorgesehen, dass die Säule eine konische Form aufweist, wobei ein Durchmesser der Säule zumindest teilweise von unten nach oben (in Längsrichtung der Säule) abnimmt. In einer alternativen Ausführungsform ist die Säule zylindrisch ausgebildet. In einer alternativen Ausführungsform ist der Querschnitt einer Säule dargestellt durch eine Fläche, die durch eine gekrümmte Linie umschlossen wird.

In einer bevorzugten Ausführungsform ist das mindestens eine photovoltaische Element als eine mit mindestens einer photoaktiven Schicht beschichtete flexible Folie ausgebildet, wobei bevorzugt die flexible Folie an eine Oberfläche anpassbar ist, insbesondere in bestimmten Grenzen dehnbar ist, so das Unterschiede in der Länge und/oder Breite ausgleichbar sind.

In einer bevorzugten Ausführungsform ist der Durchmesser der Säule geringer als deren Ausdehnung in Längsrichtung. In einer bevorzugten Ausführungsform weist die Säule einen Durchmesser von mindestens 8 cm auf, bevorzugt mindestens 10 cm, bevorzugt mindestens 30 cm, bevorzugt mindestens 50 cm, bevorzugt mindestens 70 cm, bevorzugt mindestens 1 m, oder bevorzugt mindestens 2 m.

Gemäß einer Weiterbildung der Erfindung ist vorgesehen, dass das mindestens eine flexible photovoltaische Element stoffschlüssig, insbesondere geklebt, auf der Säule befestigt ist. In einer bevorzugten Ausführungsform ist das mindestens eine flexible photovoltaische Element auf der Säule fixiert.

In einer bevorzugten Ausführungsform weist das mindestens eine photovoltaische Element auf der Rückseite eine selbstklebende Beschichtung auf, so dass das mindestens eine photovoltaische Element auf eine Oberfläche befestigbar, insbesondere klebbar, ist. In einer bevorzugten Ausführungsform erstreckt sich die selbstklebende Beschichtung über die gesamte oder zumindest weitgehend über die gesamte Rückseite des photovoltaischen Elements. Dadurch wird kein zusätzliches Gerüst und/oder kein Rahmen zur Befestigung des mindestens einen photovoltaischen Elements benötigt, wodurch die Installation des mindestens einen photovoltaischen Elements einfacher und günstiger ist.

Gemäß der Erfindung ist vorgesehen, dass das flexible photovoltaische Element formschlüssig an der Säule befestigt ist.

Die Anordnung der photovoltaischen Elemente auf der Säule, insbesondere die Installation der photovoltaischen Elemente auf der Säule, besteht insbesondere aus in Reihe und/oder parallel verschalteten photovoltaischen Elementen.

Gemäß einer Weiterbildung der Erfindung ist vorgesehen, dass die Verschaltung der photovoltaischen Elemente bereichsweise voneinander getrennt ist, bevorzugt sind auf der Säule in einer ersten Himmelsrichtung ausgerichtete photovoltaische Elemente von der Verschaltung auf der Säule in einer zweiten Himmelsrichtung ausgerichteten Elemente voneinander getrennt, wobei bevorzugt jeweils jede Verschaltung in einem elektrischen Arbeitsbereich betrieben ist, insbesondere jeweils ein Inverter zugeordnet ist, insbesondere ein 3-Phasen Inverter. Dadurch ist die Erzeugung von elektrischer Energie durch die photovoltaischen Elemente zu den unterschiedlichen Tageszeiten mit entsprechend unterschiedlicher Sonneneinstrahlung besonders effektiv.

In einer bevorzugten Ausführungsform verlaufen die Kabel der Verschaltung horizontal und vertikal zwischen den photovoltaischen Elementen.

In einer bevorzugten Ausführungsform ist die Verschaltung von auf der Säule in Ost-Süd/Ost-Richtung ausgerichteten photovoltaischen Elementen von der Verschaltung von auf der Säule in West-Süd/West-Richtung ausgerichteten photovoltaischen Elementen voneinander getrennt. Die Himmelsrichtung bezieht sich dabei auf Standorte auf der Nordhalbkugel der Erde. Die Polungsbedingungen sind auf der Südhalbkugel umgekehrt zu denen auf der Nordhalbkugel. In einer bevorzugten Ausführungsform ist die Verschaltung, insbesondere die Kabel der Verschaltung, zumindest teilweise fixiert, insbesondere mittels magnetischer Befestigungen und/oder in die Oberfläche der Säule integrierte Kabelkanäle. Vorzugsweisung weist die Säule mindestens ein in das Innere der Säule führendes Loch auf, wobei die Kabel der Verschaltung in das Innere der Säule geführt sind. In einer bevorzugten Ausführungsform ist die Verschaltung mehrerer photovoltaischer Elemente durch das eine Loch geführt. In einer bevorzugten Ausführungsform weist die Säule mehrere in das Innere der Säule führende Löcher auf. Vorzugsweise ist für jede Reihe photovoltaischer Elemente ein Loch vorgesehen, durch das Kabel einer Verschaltung in das Innere der Säule geführt sind.

In einer bevorzugten Ausführungsform sind die photovoltaischen Elemente in Abhängigkeit der Einstrahlung des Sonnenlichts auf der Oberfläche der Säule angeordnet, wobei die photovoltaischen Elemente bevorzugt an einer starken Sonneneinstrahlung zugewandten Seite der Säule angeordnet sind.

In einer bevorzugten Ausführungsform weist die Säule eine Speichereinheit zum Speichern von elektrischer Energie auf, insbesondere einen Akkumulator, die mit dem mindestens einen photovoltaischen Element wirkverbunden ist, so dass die mittels des mindestens einen photovoltaischen Elements gewonnene elektrische Energie speicherbar ist.

In einer bevorzugten Ausführungsform weist die Säule mindestens einen Hohlraum auf, wobei Kabel, ein Wandler und/oder die Speichereinheit, insbesondere der Akkumulator, in dem mindestens einen Hohlraum anordbar sind.

Das photovoltaische Element, insbesondere die Solarzelle, umfasst mindestens eine Schicht einer organischen Zelle, mindestens zwei Kontakte, wobei ein Kontakt in Substratnähe als Grundkontakt oder Grundelektrode und ein substratferner Kontakt als Deckkontakt oder Deckelektrode bezeichnet wird.

In einer bevorzugten Ausführungsform ist eine Anordnung von photovoltaischen Elementen installiert, die im Einsatz teilverschattet sein kann, wobei insbesondere trotz der Teil-Verschattung eine verbesserte Effizienz und eine längere Lebensdauer der photovoltaischen Elemente ermöglicht wird.

In einer bevorzugten Ausführungsform weist das mindestens eine photovoltaische Element eine integrierte Bypass-Diode auf, wobei die Bypass-Diode auf die Zellen des photovoltaischen Elements aufgedruckt oder aufgedampft ist. Die Bypass-Diode ist in Sandwichanordnung zwischen einem gemeinsamen Grundkontakt und einem Deckkontakt angeordnet. Dadurch wird insbesondere bei einer Teil-Verschattung einzelner photovoltaischer Elemente verhindert, beispielsweise bei einer Teil-Verschattung durch die Rotorblätter einer Windkraftanlage, dass die verschatteten Zellen in Sperrrichtung geschaltete Dioden bezüglich der dazu in Reihe verschalteten, unverschatteten oder schwächer verschatteten Zellen darstellen, so dass eine Verhinderung des Abflusses der elektrischen Energie, was sich negativ auf die Effizienz der Module auswirkt, vermieden wird.

In einer bevorzugten Ausführungsform ist die Bypass-Diode parallel zu mehreren optoelektronischen Zellen angeordnet. Dadurch wird bei einer (Teil-)Verschattung, wenn der Stromfluss in der Zelle abnimmt, ein höherer Stromfluss in Sperrrichtung der Zelle bei gegebener Spannung ermöglicht.

In einer bevorzugten Ausführungsform sind die Bypass-Dioden parallel zu den Streifen der optoelektronischen Zellen angeordnet oder in die Streifen der optoelektronischen Zellen integriert.

In einer bevorzugten Ausführungsform sind die photovoltaischen Elemente über Wechselrichter verschaltet.

Die Aufgabe der vorliegenden Erfindung wird auch gelöst, indem eine Windkraftanlage zur Umwandlung der Strömungsenergie des Winds in elektrische Energie mit einer erfindungsgemäßen Säule mit mindestens einem photovoltaischen Element zur Umwandlung der Strahlungsenergie des Lichts in elektrische Energie bereitgestellt wird, insbesondere nach einem der zuvor beschriebenen Ausführungsbeispiele. Die Windkraftanlage weist dabei die Säule und eine Turbine mit Rotorblättern auf, wobei die Turbine an einem Ende der Säule angeordnet ist, und wobei mittels der Turbine ein Generator antreibbar ist, wobei an der Säule mindestens ein flexibles photovoltaisches Element angeordnet ist. Dabei ergeben sich für die Windkraftanlage insbesondere die Vorteile, die bereits in Zusammenhang mit der Säule mit dem mindestens einen photovoltaischen Element beschrieben wurden.

Aus dem Stand der Technik sind keine Windkraftanlagen bekannt, die formschlüssig direkt auf der Oberfläche der Säule der Windkraftanlage angeordnete flexible photovoltaische Elemente aufweisen.

In einer bevorzugten Ausführungsform ist das photovoltaische Element als System zur Erzeugung von Energie aus Strahlungsenergie des Lichts ausgebildet. In einer bevorzugten Ausführungsform ist die Windkraftanlage als System zur Erzeugung von elektrischer Energie aus Windkraft ausgebildet. In einer bevorzugten Ausführungsform ist das System zur Energiegewinnung durch das mindestens eine photovoltaische Element mit dem System zur Energiegewinnung durch die Windkraftanlage gekoppelt.

Vorteilhafterweise ist die parallele Erzeugung von elektrischer Energie aus der Windkraftanlage und der Photovoltaikanlage möglich. Vorteilhafterweise werden durch die formschlüssig auf der Säule angebrachten photovoltaischen Elemente keine Turbulenzen des Winds erzeugt, die eine Energiegewinnung durch die Turbine mit den Rotorblättern beeinträchtigen. Vorteilhafterweise werden Vögel von der Windkraftanlage abgehalten, insbesondere durch eine Spiegel- und/oder Farbeffekt der photovoltaischen Elemente. Vorteilhafterweise wird die Funktion der Rotorblätter der Windkraftanlage nicht beeinträchtigt. Vorteilhafterweise wird die Effektivität der Windkraftanlagen durch die Kombination mit photovoltaischen Elementen gesteigert. Vorteilhafterweise kann die durch die photovoltaischen Elemente gewonnene elektrische Energie zum Betrieb der Windkraftanlage eingesetzt werden, insbesondere bei Windstille.

Unter einer Windkraftanlage wird insbesondere ein Windrad, eine Windmühle oder ein Windkraftkonverter verstanden. Die Windkraftanlage wandelt Windenergie, also Strömungsenergie des Winds, in elektrische Energie um, die dann in ein Stromnetz einspeisbar ist. Die Windkraftanlage kann auf eine dem Fachmann bekannt Weise an dem entsprechenden Standort befestigt sein.

In einer bevorzugten Ausführungsform ist die mittels des mindestens einen photovoltaischen Elements gewonnene Energie zum Betrieb der Windkraftanlage einsetzbar, insbesondere zum Start der Turbine, zur Unterstützung der Turbine, zur Beleuchtung und/oder für ein Steuergerät.

In einer bevorzugten Ausführungsform ist die Turbine an der Säule relativ zu der Säule drehbar angeordnet.

In einer bevorzugten Ausführungsform ist die Turbine mit einem Generator wirkverbunden, so dass die Windkraft in elektrische Energie umgewandelt werden kann.

Gemäß einer Weiterbildung der Erfindung ist vorgesehen, dass das mindestens eine photovoltaische Element zumindest bereichsweise quer um die Längsachse der Säule, bevorzugt um die ganze Längsachse der Säule, angeordnet ist. Vorzugsweise ist das mindestens eine photovoltaische Element, insbesondere das quer um die Längsachse der Säule angeordnete photovoltaische Element, auf die Oberfläche der Säule geklebt.

Gemäß einer Weiterbildung der Erfindung ist vorgesehen, dass die Windkraftanlage eine Vielzahl an flexiblen photovoltaischen Elementen aufweist, wobei insbesondere eine erste Verschaltung von auf der Oberfläche der Säule in einer ersten Himmelsrichtung befestigten flexiblen photovoltaischen Elementen von einer zweiten Verschaltung von auf der Oberfläche der Säule in einer zweiten Himmelsrichtung befestigten flexiblen photovoltaischen Elemente voneinander getrennt ist, insbesondere nicht miteinander wirkverbunden ist, wobei bevorzugt die beiden Verschaltungen jeweils in einem elektrischen Arbeitsbereich betrieben sind, insbesondere jeweils ein Inverter zugeordnet ist, insbesondere ein 3-Phasen Inverter.

In einer bevorzugten Ausführungsform ist ergänzend mindestens ein photovoltaisches Element, insbesondere eine Solarzelle, auf den Rotorblättern der Windkraftanlage angeordnet.

In einer bevorzugten Ausführungsform ist die Windkraftanlage auf dem Land oder auf dem Wasser, entweder schwimmend oder fest mit dem Grund verbunden, installiert. In einer bevorzugten Ausführungsform ist die Windkraftanlage auf dem flachen Land oder in einer hügeligen Landschaft, insbesondere einem Gebirge, installiert.

Die Aufgabe der vorliegenden Erfindung wird auch gelöst, indem die Verwendung mindestens eines flexiblen photovoltaischen Elements an einer Säule oder die Verwendung mindestens eines flexiblen photovoltaischen Elements an einer Windkraftanlage bereitgestellt wird, insbesondere nach einem der zuvor beschriebenen Ausführungsbeispiele. Dabei ergeben sich für die Verwendung des mindestens einen flexiblen photovoltaischen Elements an der Säule und die Verwendung des mindestens einen flexiblen photovoltaischen Elements an der Windkraftanlage insbesondere die Vorteile, die bereits in Zusammenhang mit der Säule und/oder der Windkraftanlage beschrieben wurden.

Die Erfindung wird im Folgenden anhand der Zeichnungen näher erläutert. Dabei zeigen:
FIG. 1 eine schematische Darstellung einer ersten Ausführungsform einer Windkraftanlage mit flexiblen photovoltaischen Elementen in einer Frontansicht (Fig. 1B) und zwei Seitenansichten (Fig. 1A und 1C),
FIG. 2 eine schematische Darstellung einer zweiten Ausführungsform einer Windkraftanlage mit flexiblen photovoltaischen Elementen in einer Seitenansicht (Fig. 2, links) und einer Anordnung darauf befestigter photovoltaischer Elemente (Fig. 2, rechts), und
FIG. 3 eine schematische Darstellung einer dritten Ausführungsform einer Windkraftanlage mit flexiblen photovoltaischen Elementen.

### Ausführungsbeispiele

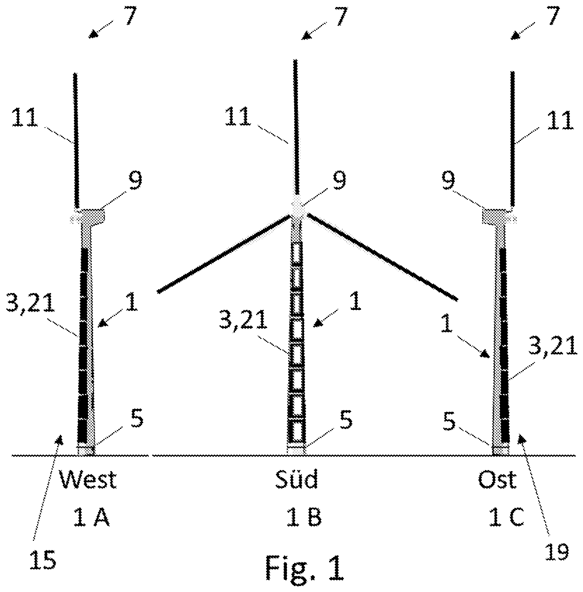

FIG. 1 zeigt eine schematische Darstellung einer ersten Ausführungsform einer erfindungsgemäßen Windkraftanlage 7 mit einer Säule 1 mit flexiblen photovoltaischen Elementen 3 in einer Frontansicht (Fig. 1B) und zwei Seitenansichten (Fig. 1A und 1C).

In dem vorliegenden Ausführungsbeispiel ist die Säule 1 eine Säule 1 einer Windkraftanlage 7. Die Säule 1 kann jedoch auch eine von der Windkraftanlage 7 unabhängige Säule 1 sein. Die Säule 1 kann aus Holz, Stahl, insbesondere einem Stahlgerüst, und/oder Beton ausgebildet sein.

Die Säule 1 weist photovoltaische Elemente 3, insbesondere Solarzellen 21, zur Umwandlung von Strahlungsenergie des Lichts, insbesondere des Sonnenlichts, in elektrische Energie auf, wobei die photovoltaischen Elemente 3 an der Säule 1 angeordnet sind. Die photovoltaischen Element 3 sind flexible photovoltaische Elemente 3, insbesondere organische photovoltaische Elemente 3 auf Basis kleiner Moleküle. Die photovoltaischen Elemente 3 sind in diesem Ausführungsbeispiel auf die Oberfläche der Säule 1 geklebt. Dazu können die photovoltaischen Elemente 3 auf der Rückseite mit einem Klebstoff beschichtet sein.

Die Windkraftanlage 7 zur Umwandlung der Strömungsenergie des Winds in elektrische Energie mit der Säule 1 mit photovoltaischen Elementen 3 zur Umwandlung der Strahlungsenergie des Lichts in elektrische Energie ist in Fig. 1 dargestellt. Die Windkraftanlage 7 weist die Säule 1 und eine Turbine 9 mit Rotorblättern 11 auf, wobei die Turbine 9 an einem Ende der Säule 1 angeordnet ist. Mittels der Turbine 9 ist ein Generator antreibbar, der die Windenergie in elektrische Energie umwandelt. Der Generator kann in der Turbine 9 oder in einem Hohlraum der Säule 1 angeordnet sein. Die photovoltaischen Elemente 3 sind flexible photovoltaische Elemente 3.

In dem vorliegenden Ausführungsbeispiel ist das flexible photovoltaische Element 3, also die Solarzelle 21, ein flexibles organisches Photovoltaik-Element (OPV) auf Basis kleiner Moleküle, es ist aber auch die Verwendung anderer flexibler photovoltaischen Elemente 3 denkbar.

In dem Ausführungsbeispiel beträgt die Höhe der Säule 1 der Windkraftanlage 7 80 m, wobei auch andere Höhen denkbar sind. Weiterhin sind in dem Ausführungsbeispiel bis zu einer Höhe von 50 m Solarzellen 21 auf der Säule 1 angeordnet und die Installation der Solarzellen 21 beginnt bei einer Höhe von ca. 3 m.

Die Abmessung der Solarzellen 21 (HeliaSol^{®} 308-5986) beträgt 5,986 x 0,308 m, wobei beispielsweise insgesamt 120 solcher Solarzellen 21 auf der Säule 1 angeordnet sind. Die Abmessungen der Solarzellen 21 können jedoch den Abmessungen der Säule 1 angepasst werden. HeliaSol^{®} Module weisen jeweils 2 Anschlüsse auf der Frontseite der Module auf. Der Azimut der Module ist variabel und die Neigung der Module auf der Oberfläche der Säule 1 beträgt 90°. Die Breite der einzelnen nebeneinander in Querrichtung angeordneten Solarzellen 21 ist gleich, es ist allerdings auch denkbar Solarzellen 21 mit einer unterschiedlichen Breite nebeneinander anzuordnen. In dem vorliegenden Ausführungsbeispiel sind 8 Reihen mit Solarzellen 21 in Längsrichtung der Säule 1 benachbart übereinander angeordnet.

In diesem Ausführungsbeispiel sind die Solarzellen 21 in Querrichtung, also in Querrichtung der Zellen des Elements relativ zur Längsrichtung der Säule 1, um die Säule 1 angeordnet.

In einem alternativen Ausführungsbeispiel werden die Solarzellen 21 in Längsrichtung, also parallel relativ zur Längsrichtung der Säule 1, an der Säule 1 angeordnet.

In einer Ausgestaltung der Erfindung sind die flexiblen photovoltaischen Elemente 3 quer und/oder längs, insbesondere auch schräg, relativ zu der längsten Ausdehnung der Säule 1 angeordnet.

In einer weiteren Ausgestaltung der Erfindung weist die Säule 1 mehrere Reihen an flexiblen photovoltaischen Elementen 3 auf, wobei die mehreren Reihen an flexiblen photovoltaischen Elementen 3 quer und/oder längs, insbesondere auch schräg, relativ zu der längsten Ausdehnung der Säule 1 angeordnet sind, und wobei eine Reihe mindestens zwei flexible photovoltaische Elemente 3 aufweist.

In dem vorliegenden Ausführungsbeispiel weist die Säule 1 eine konische Form auf, wobei ein Durchmesser 5 der Säule 1 zumindest teilweise von unten nach oben abnimmt.

In dem vorliegenden Ausführungsbeispiel nimmt bei einem derartigen konischen Verlauf des Durchmessers der Säule 1 die Anzahl der in Querrichtung nebeneinander angeordneten photovoltaischen Elemente 3 von unten nach oben in Längsrichtung der Säule 1 ab. Alternativ ist es denkbar die Abmessungen der photovoltaischen Elemente 3 dem Durchmesser der Säule 1 anzupassen.

In einer weiteren Ausgestaltung der Erfindung sind die flexiblen photovoltaischen Elemente 3 zumindest bereichsweise quer um die Längsachse der Säule 1, bevorzugt um die ganze Längsachse der Säule 1, angeordnet.

In einer weiteren Ausgestaltung der Erfindung sind die flexiblen photovoltaischen Elemente 3 formschlüssig an der Säule 1 befestigt, indem die photovoltaischen Elemente 3 auf die Oberfläche der Säule 1 geklebt sind.

In dem vorliegenden Ausführungsbeispiel ist eine erste Verschaltung 13 von auf der Oberfläche der Säule 1 in einer ersten Himmelsrichtung 15 (siehe Figur 1A und 1B) befestigten flexiblen photovoltaischen Elementen 3 von einer zweiten Verschaltung 17 von auf der Oberfläche der Säule 1 in einer zweiten Himmelsrichtung 19 (siehe Figur 1B und 1C) befestigten flexiblen photovoltaischen Elementen 3 voneinander getrennt, wobei die beiden Verschaltungen 13,17 jeweils in einem elektrischen Arbeitsbereich betrieben sind, insbesondere jeweils ein Inverter zugeordnet ist.

In dem vorliegenden Ausführungsbeispiel ist die Verschaltung 17 der in Ost-Süd/Ost-Richtung angeordneten Solarzellen 21 von der Verschaltung 13 der in West-Süd/West-Richtung angeordneten Solarzellen 21 voneinander getrennt. Durch die getrennte Verschaltung 13,17 in Abhängigkeit der Himmelsrichtungen 15,19 ist die Säule 1 in zwei Bereiche aufgeteilt, einem der Ost-Süd/Ost Richtung zugewandten Bereich einem der West-Süd/West Richtung zugewandten Bereich (bezogen auf die Himmelsrichtungen auf Standorte auf der Nordhalbkugel der Erde). Jedem dieser Bereiche zugeordnete Inverter ist mit 60 Solarzellen 21 verbunden. Die Inverter sind 2 MPPT (Maximum Power Point Tracking) Inverter mit 3 Phasen. Die maximale Leistung der Inverter beträgt 4,68 kW. Der Spannungsbereich beträgt minimal 200 V und maximal 495,6 V, die maximale Stromstärke beträgt 16,3 A pro Inverter und 9,78 A pro MPPT.

In einer Ausgestaltung der Erfindung ist die Verschaltung 13,17, insbesondere der Verlauf eines Kabels der Verschaltung 13,17, zumindest teilweise horizontal und vertikal zwischen den photovoltaischen Elementen 3 angeordnet.

In einer weiteren Ausgestaltung der Erfindung sind an der Oberfläche der Säule 1 Kabelkanäle angeordnet in denen die Kabel geführt sind.

In dem vorliegenden Ausführungsbeispiel sind die Solarzellen 21 auf der Säule 3 in den Himmelsrichtungen Ost (Fig. 1 A), Süd (Fig. 1 B) und West (Fig. 1 C) angeordnet, während in Nord-Richtung keine Solarzelle 21 angeordnet ist. Dadurch sind die Solarzellen 21 besonders gut der Einstrahlung des Sonnenlichts nach ausgerichtet. Dies deshalb, da in Nord-Richtung ein geringerer Eintrag von Sonnenlicht zu erwarten ist. In einem alternativen Ausführungsbeispiel ist allerdings denkbar, dass die Solarzellen 21 zusätzlich in Nord-Richtung angeordnet sind, insbesondere um die Oberfläche der gesamten Säule 1 weitgehend zu nutzen und zu schützen.

Der Anschluss der Solarzellen 21 verläuft durch in Querrichtung zu der Säule 1 extern geführte Kabel zwischen den Solarzellen 21, wobei jeweils ein Kabel zwischen jeder zweiten Reihe an Solarzellen 21 geführt ist (in Längsrichtung zu der Säule 1 gesehen). Auf der Vorderseite der Solarzellen 21 ist jeweils ein Anschluss angeordnet, an den die Kabel der Verschaltung 13,17 angeschlossen sind. Als Anschluss kann beispielsweise ein Connector MC4 verwendet werden (Multicontact TwinBox mit integriertem MC4 Connector).

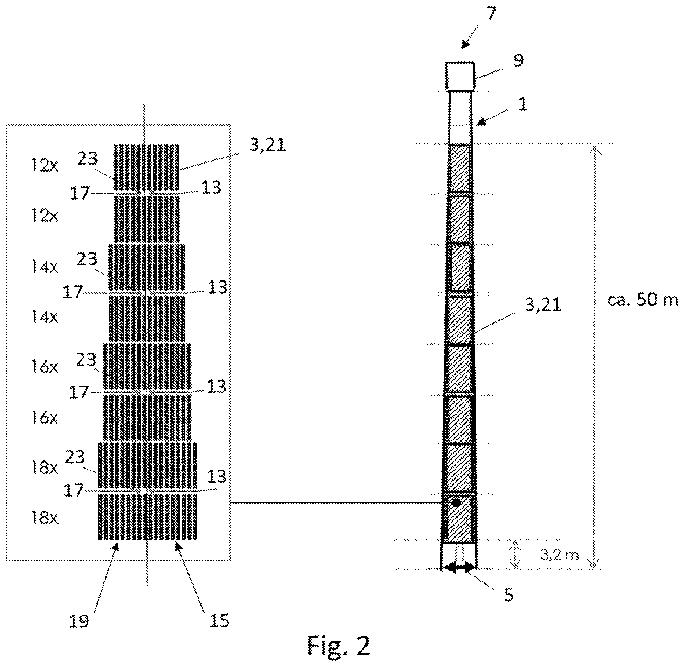

Die Säule 1 weist in das Innere der Säule 1 führende Löcher 23 auf, wodurch die Verschaltungen 13,17 in das Innere der Säule 1 geführt ist. Die Kabel der Verschaltungen 13,17 sind durch die Löcher 23 in das Innere der Säule 1 geführt (Fig. 2, links) und dort mit einem Wandler und/oder eine Speichereinheit verbindbar. In einer Ausgestaltung der Erfindung ist für jede Reihe an Solarzellen 21 jeweils ein Loch 23 für die Verschaltungen 13,17 vorgesehen.

In einer Ausgestaltung der Erfindung weist die Säule 1 einen Hohlraum auf, in dem der Wandler und/oder die Speichereinheit angeordnet sind.

In einer Ausgestaltung der Erfindung ist die Verschaltung 13,17, insbesondere ein Kabel der Verschaltung 13,17, zumindest teilweise fixiert, insbesondere mittels magnetischer Befestigungen und/oder in die Oberfläche der Säule 1 integrierte Kabelkanäle.

In einer weiteren Ausgestaltung der Erfindung weist die Säule 1 eine Speichereinheit, insbesondere einen Akkumulator, zum Speichern der elektrischen Energie auf, wobei die Speichereinheit mit der mindestens einen Solarzelle 21 verbunden ist.

In einer weiteren Ausgestaltung der Erfindung ist die Speichereinheit und/oder der Wandler in einem Hohlraum der Säule 1 angeordnet.

FIG. 2 zeigt eine schematische Darstellung einer zweiten Ausführungsform einer Windkraftanlage 7 mit flexiblen photovoltaischen Elementen 3 in einer Seitenansicht (Fig. 2, rechts) und einer Anordnung darauf befestigter photovoltaischer Elemente 3 (Fig. 2, links). Gleiche und funktionsgleiche Elemente sind mit den gleichen Bezugszeichen versehen, so dass insofern auf die vorangegangene Beschreibung verwiesen wird.

Die Installation der photovoltaischen Elemente 3, also der Solarzellen 21 (in dem vorliegenden Ausführungsbeispiel HeliaSol^{®} 6000), auf der Säule 1 beginnt ab einer Höhe von ca. 3 m der Säule 1 und endet bei einer Höhe von gut 50 m der Säule 1 Fig. 2, rechts). In Abhängigkeit der Höhe der Säule 1 ist auch eine Installation der Solarzellen 21 bis zu einer größeren Höhe denkbar.

Der Durchmesser 5 der Säule 1 nimmt aufgrund der konischen Form von unten nach oben ab, wodurch die ringförmig um die Längsrichtung der Säule 1 zur Verfügung stehende Fläche abnimmt. Die Anzahl der in Querrichtung zur Säule 1 angeordneten Solarzellen 21 nimmt in dem vorliegenden Ausführungsbeispiel deshalb von unten nach oben ebenfalls ab. Es sind 8 Reihen von Solarzellen 21 auf der Oberfläche der Säule 1 angeordnet, wobei jeweils zwei aneinandergrenzende Reihen die gleiche Anzahl an Solarzellen 21 aufweisen. In der ersten und zweiten Reihe sind jeweils 18 Solarzellen 21 angeordnet, wobei sich bevorzugt jeweils einzelne Solarzellen 21 gegenüberliegen, in der dritten und vierten Reihe sind jeweils 16 Solarzellen 21 angeordnet, in der fünften und sechsten Reihe sind jeweils 14 Solarzellen 21 angeordnet, und in der siebten und achten Reihe sind jeweils 12 Solarzellen 21 angeordnet Durch die Verwendung von flexiblen Solarzellen 21 ist eine formschlüssige Befestigung der Solarzellen 21 auch bei einer konisch geformten Säule 1 trotz einem noch oben hin abnehmenden Durchmesser 5 und einer damit verbunden kleiner werdenden Fläche möglich.

Die Solarzellen 21 sind über die Verschaltung 13,17 mit einem elektrischen Teilsystem wirkverbunden, insbesondere einem Wandler und/oder einer Speichereinheit. Die Kabel der Verschaltung 13,17 sind über Anschlüsse an die Solarzellen 21 angebunden, werden über die Löcher 23 in das Innere der Säule 1 geführt, und dort an den Wandler und/oder eine Speichereinheit angebunden.

In einer Ausgestaltung der Erfindung weisen jeweils zwei in Querrichtung zu der Säule 1 benachbart angeordnete Reihen mit Solarzellen 21 eine gleiche Anzahl an Solarzellen 21 auf. Eine derartig paarweise Anordnung der Solarzellen 21 ermöglicht eine Führung der Kabel der Verschaltungen 13,17 zwischen lediglich jeder zweiten Reihe, wodurch die Installation der Solarzellen 21 erleichtert wird. Vorzugsweise sind die Solarzellen jeder zweiten Reihe dabei um 180° gegeneinander gedreht. Des Weiteren wird jeweils für zwei Reihen an Solarzellen 21 lediglich ein Loch 23 benötigt, durch das die Verschaltung 13,17 in das Innere der Säule 1 geführt ist.

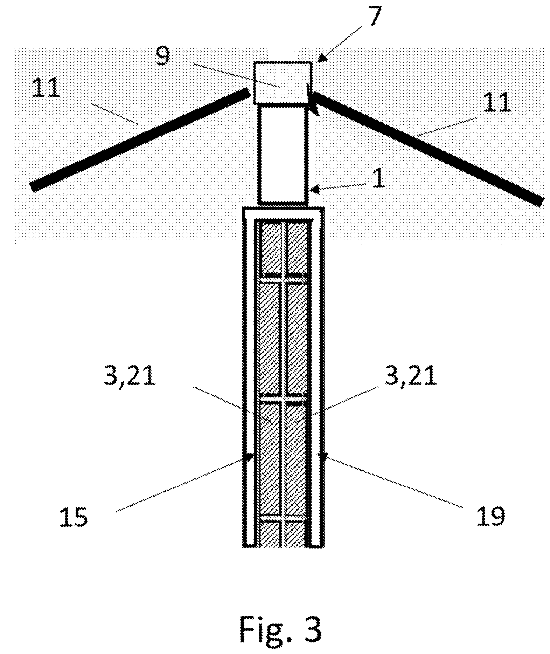

FIG. 3 zeigt eine schematische Darstellung einer dritten Ausführungsform einer Windkraftanlage 7 mit flexiblen photovoltaischen Elementen 3. Gleiche und funktionsgleiche Elemente sind mit den gleichen Bezugszeichen versehen, so dass insofern auf die vorangegangene Beschreibung verwiesen wird.

In dem vorliegenden Ausführungsbeispiel ist die Verschaltung 17 der in Ost-Süd/Ost-Richtung 19 angeordneten Solarzellen 21 von der Verschaltung 13 der in West-Süd/West-Richtung 15 angeordneten Solarzellen 21 voneinander getrennt.

In einer Ausgestaltung der Erfindung sind die Solarzellen 21 zumindest weitgehend an der gesamten Oberfläche der Säule 1 angeordnet. Dabei ist es denkbar, dass die Oberfläche der Säule 1 in mehr als zwei Bereiche aufgeteilt ist, insbesondere in Abhängigkeit der Himmelsrichtung und/oder einer Verschattung, wobei jedem Bereich eine Verschaltung zugeordnet ist, so dass neben der ersten Verschaltung 13 und zweiten Verschaltung 17 noch weitere Verschaltungen vorliegen können.

## Patentansprüche

1. Säule (1) mit mindestens einem photovoltaischen Element (3) zur Umwandlung von Strahlungsenergie des Lichts, insbesondere des Sonnenlichts, in elektrische Energie, wobei das mindestens eine photovoltaische Element (3) an der Säule (1) angeordnet ist, wobei das mindestens eine photovoltaische Element (3) ein flexibles photovoltaisches Element (3) ist, **dadurch gekennzeichnet, dass** das mindestens eine flexible photovoltaische Element (3) formschlüssig direkt auf der Oberfläche der Säule (1) angeordnet ist und stoffschlüssig geklebt auf der Säule (1) befestigt ist, wobei das flexible photovoltaische Element (3) als eine Perovskit-Zelle oder ein organisches Photovoltaik-Element ausgebildet ist, und wobei das flexible photovoltaische Element (3) einen positiven Temperaturkoeffizienten aufweist.

2. Die Säule (1) nach Anspruch 1, wobei das mindestens eine flexible photovoltaische Element (3) quer und/oder längs relativ zu der längsten Ausdehnung der Säule (1) angeordnet ist.

3. Die Säule (1) nach Anspruch 1 oder 2, wobei die Säule (1) mindestens zwei Reihen an flexiblen photovoltaischen Elementen (3) aufweist, wobei die mindestens zwei Reihen an flexiblen photovoltaischen Elementen (3) quer und/oder längs relativ zu der längsten Ausdehnung der Säule (1) angeordnet sind, und wobei eine Reihe bevorzugt mindestens zwei flexible photovoltaische Elemente (3) aufweist.

4. Die Säule (1) nach einem der vorhergehenden Ansprüche, wobei die Säule (1) eine konische Form aufweist, wobei ein Durchmesser (5) der Säule (1) zumindest teilweise von unten nach oben abnimmt.

5. Windkraftanlage (7) zur Umwandlung der Strömungsenergie des Winds in elektrische Energie mit einer Säule (1) mit mindestens einem photovoltaischen Element (3) zur Umwandlung der Strahlungsenergie des Lichts in elektrische Energie nach einem der Ansprüche 1 bis 4, wobei die Windkraftanlage (7) die Säule (1) und eine Turbine (9) mit Rotorblättern (11) aufweist, wobei die Turbine (9) an einem Ende der Säule (1) angeordnet ist, wobei mittels der Turbine (9) ein Generator antreibbar ist, wobei an der Säule (1) das mindestens eine flexible photovoltaische Element (3) angeordnet ist, **dadurch gekennzeichnet, dass** das mindestens eine photovoltaische Element (3) formschlüssig direkt auf der Oberfläche der Säule (1) angeordnet ist und stoffschlüssig auf die Oberfläche der Säule (1) geklebt ist, wobei das mindestens eine flexible photovoltaische Element (3) als eine Perovskit-Zelle oder ein organisches Photovoltaik-Element ausgebildet ist, und wobei das mindestens eine flexible photovoltaische Element (3) einen positiven Temperaturkoeffizienten aufweist.

6. Windkraftanlage (7) nach Anspruch 5, wobei das mindestens eine photovoltaische Element (3) zumindest bereichsweise quer um die Längsachse der Säule (1), bevorzugt um die ganze Längsachse der Säule (1), angeordnet ist.

7. Windkraftanlage (7) nach Anspruch 5 oder 6, wobei die Windkraftanlage (7) eine Vielzahl an flexiblen photovoltaischen Elementen (3) aufweist, wobei eine erste Verschaltung (13) von auf der Oberfläche der Säule (1) in einer ersten Himmelsrichtung (15) befestigten flexiblen photovoltaischen Elementen (3) von einer zweiten Verschaltung (17) von auf der Oberfläche der Säule (1) in einer zweiten Himmelsrichtung (19) befestigten flexiblen photovoltaischen Elementen (3) voneinander getrennt ist, wobei bevorzugt die beiden Verschaltungen (13,17) jeweils in einem elektrischen Arbeitsbereich betrieben sind.

8. Verwendung mindestens eines flexiblen photovoltaischen Elements (3) an einer Säule (1) nach einem der Ansprüche 1 bis 4 oder an einer Windkraftanlage (7) nach einem der Ansprüche 5 bis 7.

## Claims

1. Column (1) with at least one photovoltaic element (3) for converting radiation energy of light, in particular sunlight, into electrical energy, wherein the at least one photovoltaic element (3) is arranged on the column (1), wherein the at least one photovoltaic element (3) is a flexible photovoltaic element (3), **characterized in that** the at least one flexible photovoltaic element (3) is arranged in a form-fitting manner directly on the surface of the column (1) and is attached to the column (1) by an integral adhesive bond, wherein the flexible photovoltaic element (3) is in the form of a perovskite cell or an organic photovoltaic element, and wherein the flexible photovoltaic element (3) has a positive temperature coefficient.

2. Column (1) according to Claim 1, wherein the at least one flexible photovoltaic element (3) is arranged transversely and/or longitudinally relative to the longest extent of the column (1).

3. Column (1) according to Claim 1 or 2, wherein the column (1) has at least two rows of flexible photovoltaic elements (3), wherein the at least two rows of flexible photovoltaic elements (3) are arranged transversely and/or longitudinally relative to the longest extent of the column (1), and wherein one row preferably has at least two flexible photovoltaic elements (3).

4. Column (1) according to one of the preceding claims, wherein the column (1) has a conical shape, wherein a diameter (5) of the column (1) decreases at least partially from the bottom to the top.

5. Wind turbine structure (7) for converting the flow energy of wind into electrical energy with a column (1) with at least one photovoltaic element (3) for converting the radiation energy of light into electrical energy according to one of Claims 1 to 4, wherein the wind turbine structure (7) has the column (1) and a turbine portion (9) with rotor blades (11), wherein the turbine portion (9) is arranged at one end of the column (1), wherein a generator is drivable by means of the turbine portion (9), wherein the at least one flexible photovoltaic element (3) is arranged on the column (1), **characterized in that** the at least one photovoltaic element (3) is arranged in a form-fitting manner directly on the surface of the column (1) and is adhesively bonded to the surface of the column (1) by an integral bond, wherein the at least one flexible photovoltaic element (3) is in the form of a perovskite cell or an organic photovoltaic element, and wherein the at least one flexible photovoltaic element (3) has a positive temperature coefficient.

6. Wind turbine structure (7) according to Claim 5, wherein the at least one photovoltaic element (3) is at least regionally arranged transversely around the longitudinal axis of the column (1), preferably around the entire longitudinal axis of the column (1).

7. Wind turbine structure (7) according to Claim 5 or 6, wherein the wind turbine structure (7) has a multiplicity of flexible photovoltaic elements (3), wherein a first interconnection (13) of flexible photovoltaic elements (3) attached to the surface of the column (1) in a first compass direction (15) is separated from a second interconnection (17) of flexible photovoltaic elements (3) attached to the surface of the column (1) in a second compass direction (19), wherein the two interconnections (13, 17) are preferably each operated in an electrical working region.

8. Use of at least one flexible photovoltaic element (3) on a column (1) according to one of Claims 1 to 4 or on a wind turbine structure (7) according to one of Claims 5 to 7.

## Revendications

1. Colonne (1) comprenant au moins un élément photovoltaïque (3) pour la conversion de l'énergie de rayonnement de la lumière, en particulier de la lumière solaire, en énergie électrique, l'au moins un élément photovoltaïque (3) étant disposé sur la colonne (1), l'au moins un élément photovoltaïque (3) étant un élément photovoltaïque flexible (3), **caractérisée en ce que** l'au moins un élément photovoltaïque flexible (3) est disposé directement sur la surface de la colonne (1) par complémentarité de forme et est collé sur la colonne (1) par complémentarité de matériau, l'élément photovoltaïque flexible (3) étant conçu sous la forme d'une cellule de pérovskite ou d'un élément photovoltaïque organique, et l'élément photovoltaïque flexible (3) présentant un coefficient de température positif.

2. Colonne (1) selon la revendication 1, l'au moins un élément photovoltaïque flexible (3) étant disposé transversalement et/ou longitudinalement par rapport à la plus grande extension de la colonne (1).

3. Colonne (1) selon la revendication 1 ou 2, la colonne (1) comportant au moins deux rangées d'éléments photovoltaïques flexibles (3), lesdites au moins deux rangées d'éléments photovoltaïques flexibles (3) étant disposées transversalement et/ou longitudinalement par rapport à la plus grande extension de la colonne (1), et une rangée comportant de préférence au moins deux éléments photovoltaïques flexibles (3).

4. Colonne (1) selon l'une quelconque des revendications précédentes, la colonne (1) présentant une forme conique, un diamètre (5) de la colonne (1) diminuant au moins partiellement du bas vers le haut.

5. Éolienne (7) pour la conversion de l'énergie cinétique du vent en énergie électrique, comprenant une colonne (1) dotée d'au moins un élément photovoltaïque (3) pour la conversion de l'énergie de rayonnement de la lumière en énergie électrique selon l'une quelconque des revendications 1 à 4, l'éolienne (7) comportant la colonne (1) et une turbine (9) comprenant des pales de rotor (11), la turbine (9) étant disposée à une extrémité de la colonne (1), un générateur pouvant être entraîné au moyen de la turbine (9), l'au moins un élément photovoltaïque flexible (3) étant disposé sur la colonne (1), **caractérisée en ce que** l'au moins un élément photovoltaïque (3) est disposé directement sur la surface de la colonne (1) par complémentarité de forme et est collé sur la surface de la colonne (1) par complémentarité de matériau, l'au moins un élément photovoltaïque flexible (3) étant conçu sous la forme d'une cellule de pérovskite ou d'un élément photovoltaïque organique, et l'au moins un élément photovoltaïque flexible (3) présentant un coefficient de température positif.

6. Éolienne (7) selon la revendication 5, l'au moins un élément photovoltaïque (3) étant disposé au moins par zones transversalement autour de l'axe longitudinal de la colonne (1), de préférence autour de la totalité de l'axe longitudinal de la colonne (1).

7. Éolienne (7) selon la revendication 5 ou 6, l'éolienne (7) comportant une pluralité d'éléments photovoltaïques flexibles (3), une première interconnexion (13) d'éléments photovoltaïques flexibles (3) fixés sur la surface de la colonne (1) dans une première direction cardinale (15) étant séparée d'une seconde interconnexion (17) d'éléments photovoltaïques flexibles (3) fixés sur la surface de la colonne (1) dans une seconde direction cardinale (19), les deux interconnexions (13, 17) étant de préférence respectivement utilisées dans une plage de fonctionnement électrique.

8. Utilisation d'au moins un élément photovoltaïque flexible (3) sur une colonne (1) selon l'une quelconque des revendications 1 à 4 ou sur une éolienne (7) selon l'une quelconque des revendications 5 à 7.
